# EUROPEAN PATENT APPLICATION

(11) **EP 1 906 252 A1**
(43) Date of publication of application: **02.04.2008**
(21) Application number: 06020464.1
(22) Date of filing: 28.09.2006
(51) Int. Cl.: G03F 7/20, G01J 1/42, G01J 1/08

(54) **Instrument for measuring the angular distribution of light produced by an illumination system of a microlithographic projection exposure apparatus**

(71) Applicant: Carl Zeiss SMT AG, 73447 Oberkochen (DE)
(72) Inventor: Fiolka, Damian, 73447 Oberkochen (DE); Karl, Gerhard, 73441 Bopfingen (DE); Natt, Oliver, 73431 Aalen (DE)
(74) Representative: Schwanhäusser, Gernot

(57) **Abstract**

An instrument for measuring the angular distribution of light produced by an illumination system of a microlithographic projection exposure apparatus comprises pinhole (82) and a polarization conversion unit (92), for example a quarter-wave plate, that converts at least one state of polarization of the light into a circular state of polarization. An irradiance sensor (96) such as a CCD image sensor detects the spatial distribution of light having passed the pinhole (82) and being in a circular state of polarization. An aspheric collimating lens (90) may be arranged between the pinhole (82) and the polarization conversion unit (92).

## Description

### BACKGROUND OF THE INVENTION

### 1. Field of the invention

The invention relates generally to an instrument for measuring the angular distribution of light produced by an illumination system of a microlithographic projection exposure apparatus. Such apparatus are used for the production of integrated circuits and other microstructured components.

### 2. Description of Related Art

Microlithography (also called photolithography or simply lithography) is a technology for the fabrication of integrated circuits, liquid crystal displays and other microstructured devices. The process of microlithography, in conjunction with the process of etching, is used to pattern features in thin film stacks that have been formed on a substrate, for example a silicon wafer. At each layer of the fabrication, the wafer is first coated with a photoresist which is a material that is sensitive to radiation, such as deep ultraviolet (DUV) light. Next, the wafer with the photoresist on top is exposed to projection light through a mask in a projection exposure apparatus. The mask contains a circuit pattern to be projected onto the photoresist. After exposure the photoresist is developed to produce an image corresponding to the circuit pattern contained in the mask. Then an etch process transfers the circuit pattern into the thin film stacks on the wafer. Finally, the photoresist is removed. Repetition of this process with different masks results in a multi-layered microstructured component.

A projection exposure apparatus typically includes an illumination system, a mask stage for a aligning the mask, a projection lens and a wafer alignment stage for aligning the wafer coated with the photoresist. The illumination system illuminates a field on the mask that often has the shape of an (elongated) rectangle or a ring segment.

In current projection exposure apparatus a distinction can be made between two different types of apparatus. In one type each target portion on the wafer is irradiated by exposing the entire mask pattern onto the target portion in one go; such an apparatus is commonly referred to as a wafer stepper. In the other type of apparatus, which is commonly referred to as a step-and-scan apparatus or scanner, each target portion is irradiated by progressively scanning the mask pattern under the projection light beam in a given reference direction while synchronously scanning the substrate parallel or anti-parallel to this direction. The ratio of the velocity of the wafer and the velocity of the mask is equal to the magnification of the projection lens, which is usually smaller than 1, for example 1:4.

As the technology for manufacturing microstructured devices advances, there are ever increasing demands also on the illumination system. Ideally, the illumination system illuminates each point of the illuminated field on the mask with projection light having a well defined angular distribution and irradiance. Usually the angular distribution of the projection light shall be the same for all points in the illuminated field. However, it has also been proposed to illuminate different regions within the illuminated field with light having different angular distributions. For details reference is made to WO 2005/076083 A1.

The angular distribution of the projection light impinging on the mask is usually adapted to the kind of pattern to be projected onto the photoresist. For example, relatively large sized features may require a different angular distribution than small sized features. The most commonly used angular distributions of projection light are referred to as conventional, annular, dipole and quadrupole illumination settings. These terms refer to the irradiance distribution in a pupil plane of the illumination system. With an annular illumination setting, for example, only an annular region is illuminated in the pupil plane. Thus there is only a small range of angles present in the angular distribution of the projection light so that all light rays impinge obliquely with similar angles onto the mask.

Particularly for testing and quality control purposes it is necessary to measure the angular distribution of the light produced by the illumination system. A suitable instrument for doing this has been proposed in US 6,636,367 B2. The instrument comprises a light-tight housing having a small pinhole which is arranged in the mask plane during the measurements. A light bundle entering the pinhole is deflected by a plane deflection mirror and directed, after passing through a positive lens, onto a CCD (*charged coupled device*) sensor. This arrangement ensures that the angular distribution of the light in the mask plane translates into a spatial distribution on the CCD sensor. In order to prevent saturation of the CCD sensor, a wavelength insensitive attenuation element is arranged in the beam path.

In a preferred embodiment disclosed in US 6,636,367 B2 the instrument is connected to a control device that controls movements of at least one optical component, for example a lens, within the illumination optics contained in the illumination system. It is thus possible to modify the angular distribution of the light produced by the illumination system in response to the angular distribution measured by the instrument.

It has recently been discovered that illuminating the mask with projection light having a carefully selected polarization state may significantly improve the imaging of the mask pattern onto the photoresist. Sophisticated illumination systems therefore make it possible to illuminate the mask with light having a polarization state that is adapted to the mask pattern. To this end the illumination system may contain polarizers that are arranged in a pupil plane, as it is described in US 2005/0140958 A1, for example. If the angular distribution of polarized light produced by such an illumination system is to be measured, it has to be ensured that the irradiance measured by the CCD sensor does not depend on the state of polarization.

However, it has been discovered that all suitable image sensor chips, and in particular CCD sensors, do indeed display a sensitivity to the state of polarization. The maximum sensitivity difference occurs if light impinges on the sensor which is linearly polarized along either of the orthogonal longitudinal edges of the sensor chip. Typically, the irradiance measured for light which is linearly polarized in a direction parallel to one edge differs by about 2% from the irradiance which is measured for light which is in an orthogonal state of polarization. Since the irradiance distribution in the sensor plane is directly translated into the angular distribution, this sensitivity to the state of polarization results in significant errors of the angular distribution measurements.

### SUMMARY OF THE INVENTION

It is therefore an object of the present invention to provide an instrument for measuring the angular distribution of light produced by an illumination system of a microlithographic projection exposure apparatus which has a reduced sensitivity to the state of polarization.

According to a first aspect of the invention, this object is achieved by an instrument comprising:
a) a pinhole
b) a polarization conversion unit that converts at least one state of polarization of the light into a circular state of polarization, and
c) an irradiance sensor that detects the spatial distribution of light having passed the pinhole and the polarization conversion unit.

It has been discovered that converting at least one state of polarization into a circular state of polarization is the only sensible way to achieve an insensitivity to the state of polarization. Producing completely unpolarized light having a rapidly varying succession of different polarization states is difficult because it requires the use of depolarizers. However, such depolarizers destroy the direct relationship between the angular distribution at the mask plane and the spatial distribution at the sensor plane. A conversion to a *circular* state of polarization is possible with a conversion unit that does not destroy this relationship.

It is usually not necessary to convert all states of polarization to a circular state of polarization. There may be linear states of polarization with a polarization direction that can be decomposed into two equal linear components for which the sensor has the maximum and the minimum sensitivity. For such linear states of polarization the same averaging effect occurs as with a circular state of polarization.

The conversion of a state of polarization having a dominant direction (i.e. linear or elliptical state of polarization) to a circular state of polarization involves the introduction of a phase shift between two orthogonal components. For example, if the light in the mask plane is elliptically polarized, it suffices to introduce an additional phase shift β with 0° < β < 45° to convert the elliptical state of polarization to a circular state of polarization.

Usually, however, the light in the mask plane is linearly polarized with polarization directions depending on the structures contained in the mask. For converting a linear state of polarization into a circular state of polarization, the polarization conversion unit has to introduce a phase shift of (2m+1) · 90° with m = 0, 1, 2, ..., between two orthogonal states of polarization. Such a phase shift may be produced by different optical effects. For example, a phase shift of 45° is obtained at optical surfaces where total internal reflection occurs. The polarization conversion unit may then be configured as a prism that deflects the light by total internal reflection.

Another approach to introduce a phase shift is to exploit the optical effect of birefringence. The use of optical retarders comprising a birefringent crystal is a well-known technology for introducing phase shifts. Alternatively, form-birefringent structures having dimensions smaller than the wavelength of the projection light may be used for introducing the desired phase shift.

The simplest way to convert a linear state of polarization into a circular state of polarization is to use a quarter-wave plate as a polarization conversion unit. If the optic axis of the quarter-wave plate forms an angle of 45° to a linear polarization direction, circularly polarized light is obtained.

However, the polarization direction of the light in the mask plane is often not (exactly) known when the measurement is carried out. It should then be possible to carry out the measurement without determining beforehand the polarization distribution of the light.

In such a case it is possible to exploit the fact that the irradiance sensors usually display a maximum sensibility difference for light which is linearly polarized along a first direction and light which is linearly polarized along a second direction which is orthogonal to the first direction. In the case of CCD sensors, these directions correspond to the orthogonal edges of the quadratic or rectangular sensor chip. When the quarter-wave plate comprises a birefringent material having an optic axis that is arranged at 45° to the first direction, a circular state of polarization is obtained for light which is linearly polarized along the first or second direction. Light being linearly polarized along the optic axis or perpendicular thereto is in an eigenstate of the quarter-wave plate and is thus transmitted without any change of the state of polarization. Since the eigenstates comprise two equal components along the first and second directions, there is no dominant direction which could result in measurement errors due to polarization sensitivities of the irradiance sensor.

All other linear states of polarization may be decomposed into components along the first or second direction and the direction of the optic axis. Therefore these states of polarization are converted to elliptical states of polarization. However, these states do not have a dominant component along the first or second direction, and thus the measured irradiance does again not depend on the polarization direction.

The polarization conversion unit may be arranged anywhere between the illumination system and the irradiance sensor. If the polarization conversion unit is arranged in front of or behind the pinhole where the light bundle is not collimated, it should have a low sensibility to the angle of incidence. In the case of a quarter-wave plate a low order, or preferably a zero-order, plate should be used. A zero-order quarter-wave plate is characterized by introducing a phase shift of exactly 45° (and not 360° + 45°, for example). Such low-order or zero-order wave plates display a low sensitivity to oblique incidence.

If a lens having a positive refractive power is arranged between the pinhole and the irradiance sensor, the polarization conversion unit is preferably arranged between the lens and the irradiance sensor. This has the advantage that the positive lens reduces the maximum angles of incidence occurring at the wave plate. If the lens is a collimator lens that converts a diverging light bundle emerging from the pinhole into an at least substantially collimated light bundle, normal incidence on a wave plate may be obtained. Then there is no need to use low-order or even zero-order wave plates.

In many illumination systems the light in the mask plane has a numerical aperture in the order of 0.3. With a spherical positive lens and a pinhole having a finite diameter, it is not possible to accurately transform the angular distribution in the mask plane into a spatial distribution in the sensor plane. This is because spherical lenses produce significant distortion and field curvature for large numerical apertures. As a result, parallel light rays passing through the pinhole with the same (large) angle do not converge on the same point in the sensor plane. Instead, a blurred spot is produced that makes it impossible to accurately determine the angle of the light rays.

In order to maintain the desired relationship between the angular distribution in the mask plane and the spatial distribution in the sensor plane even for larger numerical apertures, it is proposed to use an aspherical lens instead of a spherical lens. Only with an aspherical lens it is possible to prevent the occurrence of blurred spots observed for larger numerical apertures. This concept may also be applied to those instruments that are not polarization insensitive in the way as has been described above.

According to another aspect of the invention, the above stated object is solved by an instrument comprising:
a) a pinhole,
b) a polarizer which is adapted to selectively pass light in one of two distinct linear states of polarization, and
c) an irradiance sensor that detects the spatial distribution of light passing the pinhole and being in either of said two linear states of polarization.

The design of this instrument is developed in view of being able to carry out a calibration of the irradiance sensor before the measurement commences. Usually the irradiance sensor displays a maximum sensibility difference for light which is in one of the two linear states of polarization and light which is in the other of the two linear states of polarization.

In a calibration measurement, which may be carried out without an illumination system, the sensitivity for light having these two linear states of polarization is independently determined. The difference of the sensitivities are recorded and used for subsequent measurements of the angular distribution.

Since the state of polarization is usually not or at least not exactly known when the angular distribution is measured, it is necessary to use the polarizer which passes only light being in one of the two distinct linear states of polarization. After a first measurement with the first polarization direction a second measurement is carried out with the second polarization direction. The results of the measurements are then computationally modified by taking into account the different sensitivities of the sensor which has been determined during the calibration measurements.

### BRIEF DESCRIPTION OF THE DRAWINGS

Various features and advantages of the present invention may be more readily understood with reference to the following detailed description taken in conjunction with the accompanying drawing in which:
- FIG. 1: is a perspective and considerably simplified view of a projection exposure apparatus in accordance with the present invention;
- FIG. 2: is a meridional section through an illumination system contained in the projection exposure apparatus shown in FIG 1;
- FIG. 3: is an enlarged meridional section through an instrument according to a first embodiment of the invention;
- FIG. 4: is a top view on a CCD image sensor showing different polarization directions;
- FIG. 5: is a top view on a CCD image sensor similar to FIG. 4, but showing other polarization directions;
- FIG. 6: is an enlarged meridional section through an instrument according to a second embodiment of the invention in a first operational state;
- FIG. 7: is an enlarged meridional section through the instrument of FIG. 7 in a second operational state.

### DESCRIPTION OF PREFERRED EMBODIMENTS

Before preferred embodiments of an instrument according to the invention are described in more detail, the general structure of a microlithographic projection exposure apparatus, and in particular of its illumination system, will be explained. This is because it is believed that certain aspects of the invention can be fully appreciated only if the technological environment where the instrument is used is thoroughly understood.

### 1. General Structure of Projection Exposure Apparatus

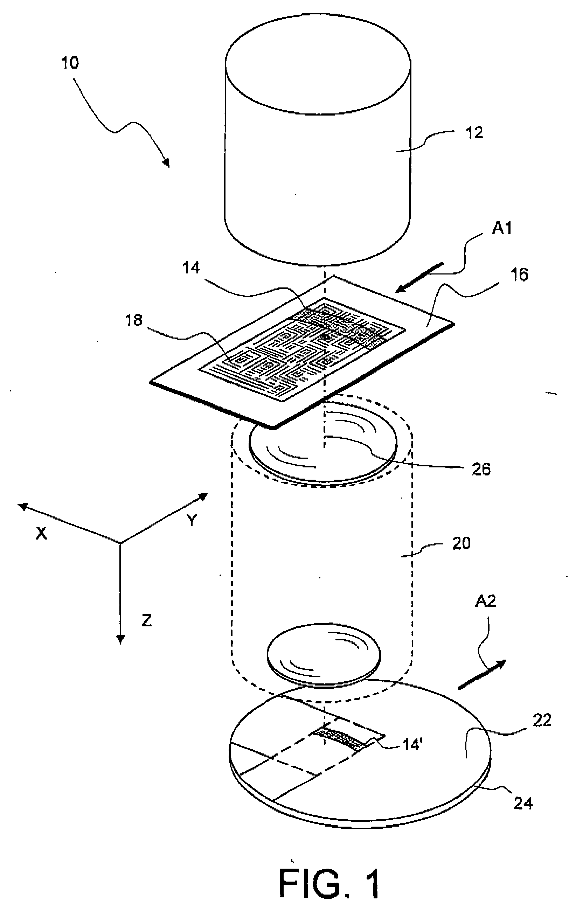

FIG. 1 is a perspective and highly simplified view of a projection exposure apparatus 10 that comprises an illumination system 12 for producing a projection light bundle. The projection light bundle illuminates a field 14 on a mask 16 containing minute structures 18. In this embodiment, the illuminated field 14 has approximately the shape of a ring segment. However, other, for example rectangular, shapes of the illuminated field 14 are contemplated as well.

A projection objective 20 images the structures 18 within the illuminated field 14 onto a light sensitive layer 22, for example a photoresist, which is deposited on a substrate 24. The substrate 24, which may formed by a silicon wafer, is arranged on a wafer stage (not shown) such that a top surface of the light sensitive layer 22 is precisely located in the image plane of the projection objective 20. The mask 16 is positioned by means of a mask stage (not shown) in an object plane of the projection objective 20. Since the latter has a magnification of less than 1, a reduced image 14' of the structures 18 within the illuminated field 14 is formed on the light sensitive layer 22.

### 2. General Structure of Illumination System

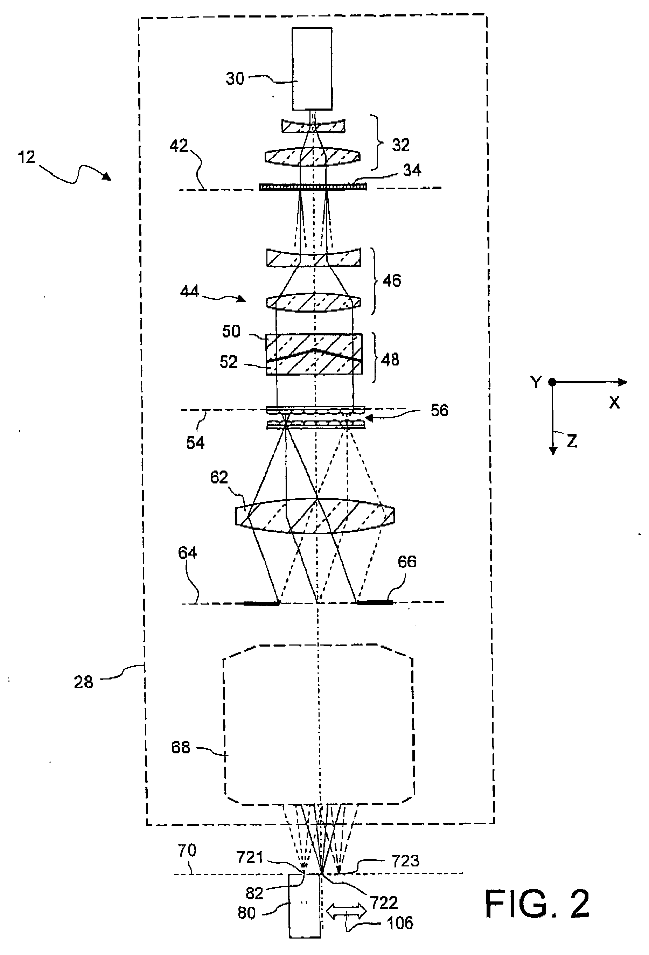

FIG. 2 is a more detailed meridional section through the illumination system 12 shown in FIG. 1. For the sake of clarity, the illustration of FIG. 2 is also considerably simplified and not to scale. This particularly implies that different optical units are represented by very few optical elements only. In reality, these units may comprise significantly more lenses and other optical elements.

The illumination system 12 comprises a housing 28 and a light source that is, in the embodiment shown, realized as an excimer laser 30. The excimer laser 30 emits projection light that has a wavelength of about 193 nm. Other types of light sources and other wavelengths, for example 248 nm or 157 nm, are also contemplated.

In the embodiment shown, the projection light emitted by the excimer laser 30 enters a beam expansion unit 32 in which the light bundle is expanded. After passing through the beam expansion unit 32, the projection light impinges on a first optical raster element 34. The first optical raster element 34 slightly increases the geometrical optical flux and modifies the local irradiance distribution in a subsequent pupil plane.

The first optical raster element 34 is positioned in an object plane 42 of an objective 44 that comprises a zoom lens group 46 and a pair 48 of axicon elements 50, 52 having opposing conical faces. If both axicon elements 50, 52 are in contact, as is shown in FIG. 2, the axicon pair 48 has the effect of a plate having parallel plane surfaces. If both elements 50, 52 are moved apart, the spacing between the axicon elements 50, 52 results in a shift of light energy radially outward. Since axicon elements are known as such in the art, these will not be explained here in further detail.

Reference numeral 54 denotes an exit pupil plane of the objective 44. An optical integrator 56 producing secondary light sources is positioned in or in close proximity to the exit pupil plane 54 of the objective 44. The optical integrator 56 modifies the angular distribution in the pupil plane 54. The angular distribution in the pupil plane 54 directly translates into an irradiance distribution in a subsequent field plane. Thus the design of the optical integrator 56 has a strong influence on_the irradiance distribution and the geometry of the illuminated field 14 on the mask 16. The angular distribution of the light on the mask 16, however, is directly related to the spatial irradiance distribution of the light in the pupil plane 54. This spatial irradiance distribution is mainly determined by the first optical raster element 34 and the positions of the elements contained in the objective 44.

The projection light emerging from the secondary light sources enters a condenser 62 that is represented in FIG. 2 by a single lens element for the sake of simplicity. The entrance pupil plane of the condenser 62 coincides with the exit pupil plane 54 of the objective 44. The condenser 62 superposes the light bundles emitted by the secondary light sources in a field stop plane 64 of the condenser 62 in which a field stop 66 is positioned. A field stop objective 68 images the field stop 66 onto a mask plane 70 in which the mask 16 is positioned during exposure operation, as it has been shown in FIG. 1.

### 3. Angular distribution of light

At the bottom of FIG. 2 three light bundles are indicated each converging to one of three points 721, 722 and 723 which are arranged in the mask plane 70 within the illuminated field 14. For the sake of simplicity it is assumed that the light bundles are formed only by the light rays that are represented by the (broken) lines shown in FIG. 2. Each light ray impinges on the mask plane 70 with a certain angle of incidence. The totality of light rays contained in a single bundle defines an angular distribution which is associated to the point to which the light rays converge. In this schematic illustration it is assumed that the angular distribution is the same for all points 721, 722, 723.

### 4. First embodiment of measuring instrument

In order to measure the angular distribution of light converging to one of the points 721, 722 and 723, an instrument 80 is provided which has a small pinhole 82. During the measurement the pinhole 82 is arranged at the point in the mask plane 70 where the angular distribution is to be measured. In FIG. 2 this is assumed to be point 721.

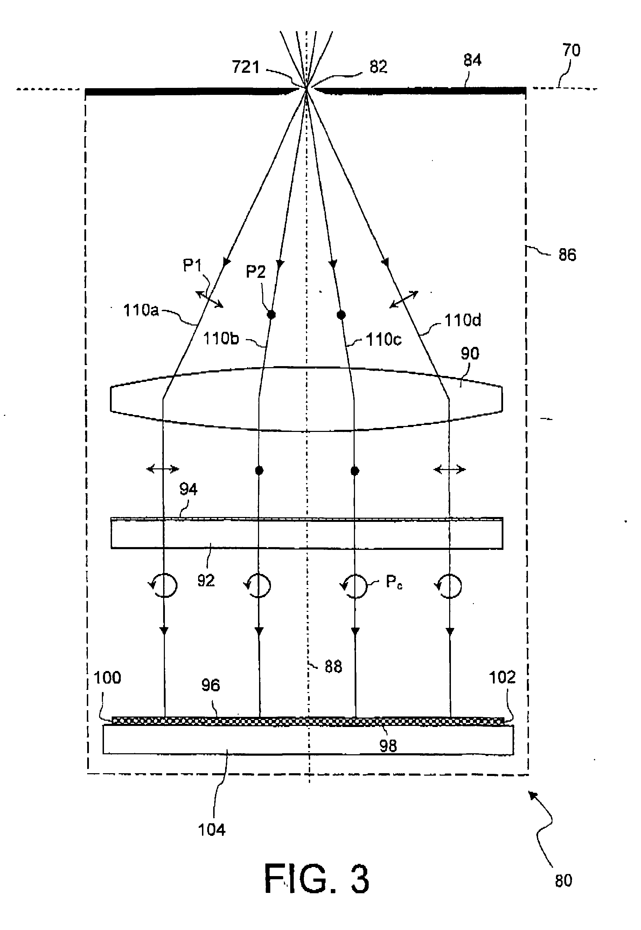

FIG. 3 shows an enlarged meridional section through the instrument 80. The pinhole 82 is formed by a small circular aperture formed in an opaque lid 84. The lid 84 covers a housing 86 which is completely opaque as well. Therefore light can enter into the inside of the instrument 80 only through the pinhole 82.

Along an optical axis 88 of the instrument 80 running through the pinhole 82 a positive aspherical lens 90, a quarter-wave plate 92 supporting an attenuation layer 94 and an irradiance sensor 96 are arranged. Since the pinhole 82 is located in the mask plane 70, the light bundle converging to the point 721 diverges inside the instrument 80. The aspherical surface of the positive lens 90 is determined such that the light bundle is, even for the rays 110a, 110d having larger angles of incidence, perfectly collimated before it impinges on the quarter-wave plate 92. As the quarter-wave plate 92 has plane and parallel surfaces that are aligned perpendicular to the optical axis 88, the light impinging on the irradiance sensor 96 is still collimated. The attenuating layer 94 causes an irradiance offset and ensures that the irradiance sensor 96 does not run into saturation.

The irradiance sensor 96 is, in the embodiment shown, realized as a CCD image chip that has a square base surface 98, which is mounted to a support 104, and four edges. Two of these edges, which will be referred to in the following as side edges, are denoted in FIG. 3 by 100, 102. The irradiance sensor 96 contains a grid of pixels each being sensitive to radiation. The signal produced by each pixel is a measure for the light energy impinging on the pixel during a certain (short) time interval. From this signal it is possible to determine the irradiance (light energy per unit area per unit time) at the respective pixel. As will be explained further below, the pixels of the irradiance sensor 96 have a polarization dependent sensitivity.

Since angles in the mask plane 70 of the light rays translate into positions in the sensor plane where the pixels are arranged, the irradiance distribution detected by the sensor 96 is used to determine the angular distribution of the light at point 721 in the mask plane 70. This determination is known in the art as such.

A high-precision stage (not shown) may be provided for moving the instrument 80 with its pinhole 82 to different positions within the illuminated field 14 in the mask plane 70. The movement is indicated in FIG. 2 by a double arrow 106. This makes it possible to measure, for a large plurality of different points in the mask plane 70, the angular distribution of the light produced by the illumination system 12 without the necessity to adjust the position of the instrument 80 for each individual measurement.

In the following it is assumed that two out of four light rays 110a, 110b, 110c and 110d entering the instrument 80 through the pinhole 82 are linearly polarized with a first polarization direction being parallel along the front and rear edges of the sensor 96, i.e. parallel to the extension of the sheet of FIG. 3. The polarization direction of these two light bundles 110a, 110d is indicated in FIG. 3 by double arrows indicated by F1. The other two rays 110b, 110c are in an orthogonal state of polarization, i.e. with a polarization direction parallel to the side edges 100, 102 of the irradiance sensor 96. This polarization direction is indicated in FIG. 3 by dots P2.

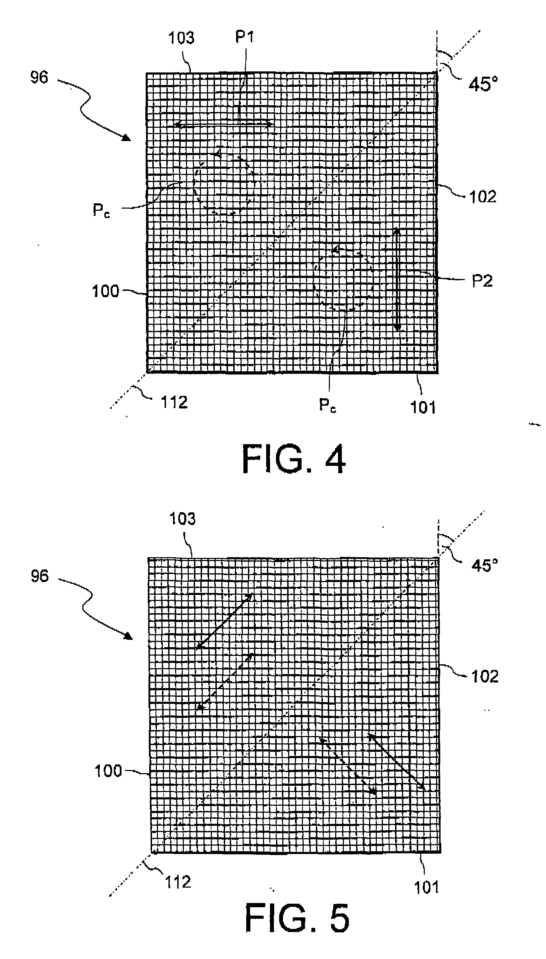

FIG. 4 shows a top view on the irradiance sensor 96 in which the orientation of the optic axis 112 of the quarter-wave plate 92 is indicated by a dot-dash line. The optic axis 112 forms an angle of 45° with respect to the side edges 100, 102 of the irradiance sensor 96. As a result of this orientation of the optic axis, the quarter-wave plate 92 converts both linear states of polarization P1, P2 of the light rays 110a to 110d into circular states of polarization, as is indicated by circles P_{c} in FIGS. 3 and 4. Thus the light rays 110a to 110d impinge on the irradiance sensor 96 without having a dominant polarization direction.

This ensures that light rays having the same intensity but a different linear state of polarization produce the same irradiance signal at the pixels of the irradiance sensor 96 where the light rays impinge. Without the quarter-wave plate 92, the light rays 110a to 110d would impinge on the irradiance sensor 96 with different linear states of polarization. Since the pixels of the irradiance sensor 96 have a polarization dependent sensitivity, this would result in different values for the measured irradiance even if the intensity of the light is identical. Usually the pixels have a sensitivity which is different for light being linearly polarized along the direction P1, which is parallel to the side edges 100, 102 on the one hand, and for light being linearly polarized along the direction P2 which is parallel to the front and rear edges 101, 103 (see FIG. 4) of the irradiance sensor 96. Thus different irradiances would be measured for the light rays 110a, 110d on the one hand and the light rays 110b, 110c on the other hand if all rays have the same intensity. Due to the provision of the quarter-wave plate 92, however, the light impinging on the irradiance sensor 96 is circularly polarized, and thus the different sensitivities of the pixels for the two orthogonal polarization directions P1, P2 do not matter.

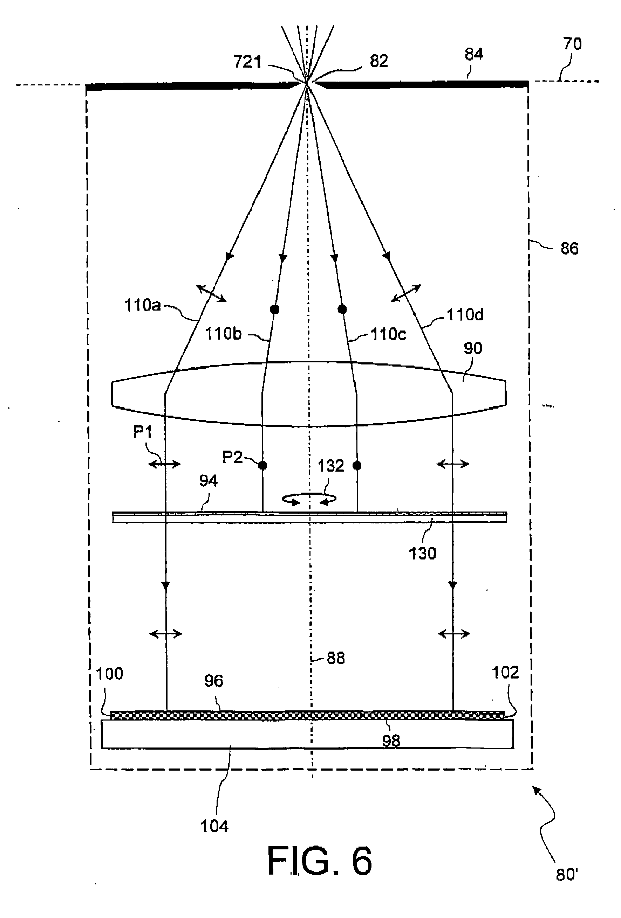

If light rays are impinging on the quarter-wave plate 92 that are linearly polarized along the optic axis 112 or perpendicular thereto, as is shown in the top view of FIG. 5, the quarter-wave plate 92 does not have any effect on the polarization, because these are eigenstates of the quarter-wave plate 92. Although such light rays have a dominant polarization direction when they impinge on the irradiance sensor 96, there is no dominant polarization component along the directions P1 and P2 where the maximum sensitivity difference occurs. Thus the different sensitivities of the irradiance sensor 96 for the different states of polarization do not matter.

Apparently the quarter-wave plate 90 does not produce light having a dominant polarization component along the edges 100, 101, 102, 103 irrespective of the polarization direction of the light impinging thereon. This may be easily understood if the polarization direction of the impinging light is decomposed into a component being parallel to the direction P1 and a component parallel to the optic axis 112. The component being parallel to the direction P1 is converted by the quarter-wave plate 92 into a circular state of polarization, whereas the component parallel to the optic axis 112 is not changed. A superposition of these two states of polarization results in an elliptical state of polarization in which the longer main axis (i.e. dominant direction) is parallel to the optic axis 112. As a result, the pixels of the irradiance sensor 96 will measure the same irradiance irrespective of the polarization direction of the light passing through the pinhole 82.

### 5. Second embodiment of measuring instrument

FIG. 6 shows a meridional section through an instrument 80' according to another aspect of the present invention. For like parts the same reference numerals as in FIG. 3 are used.

The instrument 80' differs from the instrument 80 shown in FIG. 3 mainly in that the quarter-wave plate 92 is replaced by a polarizer 130 that linearly polarizes light propagating therethrough. The polarizer 130 is mounted in this embodiment so as to be rotatable around the optical axis 88, as is indicated in FIG. 6 by a double arrow 132. The polarizer 130 may also be provided with an attenuating layer 94 attached to one of its surfaces.

In FIG. 6 the polarizer 130 is shown in a first angular position in which only the light rays 110a, 110d being polarized along the direction P1 are allowed to pass through the polarizer 130. Thus the irradiance sensor 96 detects only those components of the impinging light which have a linear polarization direction parallel to the front and rear edges 101, 103.

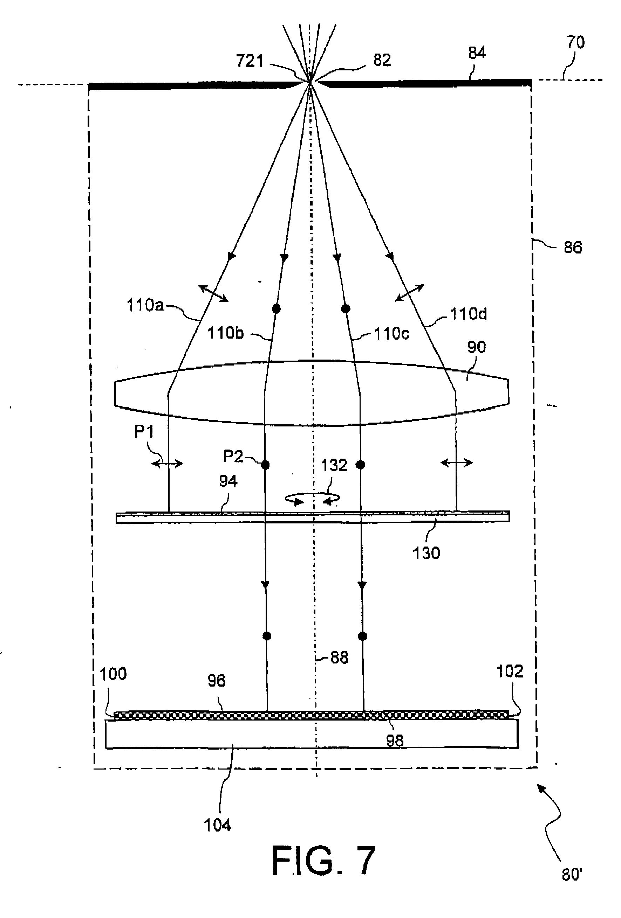

If the polarizer 130 is rotated by 90°, or replaced by another polarizer having an orthogonal polarization direction, the light rays 110a, 110d are blocked, and now the light rays 110b, 110c being polarized along the direction P2 are allowed to pass through the polarizer 130. This is shown in FIG. 7. Now the irradiance sensor 96 detects only those components of the light that have a polarization direction parallel to the side edges 100, 102.

If the sensitivity of the irradiance sensor 96 is different for both polarization directions, it is possible to take this computationally into account if a calibration measurement has been carried out beforehand. During the calibration measurement, the different sensitivities are measured with a similar setup as shown in FIGS. 6 and 7. The only difference is that the light intensity of the rays has to be known. In the simplest case unpolarized light enters through the pinhole 82. The different measurement values obtained with the two different polarization directions obtained with by the polarizer 130 result in correction parameters that are computationally accounted for during subsequent measurements of the angular distribution. For example, the irradiance values measured in the configuration shown in FIG. 7 will be multiplied with a correction parameter that accounts for the different sensitivity of the irradiance sensor 96 for light being linearly polarized along the side edges 100, 102.

## Claims

1. An instrument for measuring the angular distribution of light produced by an illumination system (12) of a microlithographic projection exposure apparatus (10), comprising:
a) a pinhole (82),
b) a polarization conversion unit (92) that converts at least one state of polarization of the light into a circular state of polarization, and
c) an irradiance sensor (96) that detects the spatial distribution of light having passed the pinhole (82) and the polarization conversion unit (92).

2. The instrument of claim 1, wherein the polarization conversion unit (92) introduces a phase shift between two orthogonal states of polarization.

3. The instrument of claim 2, wherein the polarization conversion unit (92) introduces a phase shift of (2m+1) · 90°, m = 0, 1, 2, ..., between two orthogonal states of polarization.

4. The instrument of claim 3, wherein the polarization conversion unit comprises a quarter-wave plate (92).

5. The instrument of claim 4, wherein the irradiance sensor (96) displays a maximum sensibility difference for light which is linearly polarized along a first direction (P1) and light which is linearly polarized along a second direction (P2) which is orthogonal to the first direction (P1), and wherein the quarter-wave plate (94) comprises a birefringent material having an optic axis (112) that is arranged at 45° to the first direction (P1).

6. The instrument of claim 5, wherein the irradiance sensor (96) is a CCD sensor having two pairs of orthogonal edges (100, 102; 101, 103), said edges determining the first direction (P1) and the second direction (P2).

7. The instrument of any of the preceding claims, wherein the polarization conversion unit (92) is arranged between the pinhole (82) and the irradiance sensor (96).

8. The instrument of any of the preceding claims, comprising a lens (90) having a positive refractive power which is arranged between the pinhole (82) and the irradiance sensor (96).

9. The instrument of claim 8, wherein the lens is a collimator lens (90) that converts a diverging light bundle emerging from the pinhole (82) into an at least substantially collimated light bundle.

10. The instrument of claim 9, wherein the polarization conversion unit (92) is arranged between the collimator lens (90) and the irradiance sensor (96).

11. The instrument of any of claims 8 to 10, wherein the lens is aspherical.

12. An instrument for measuring the angular distribution of light produced by an illumination system (12) of a microlithographic projection exposure apparatus (10), comprising:
a) a pinhole (82),
b) a polarizer (130) which is adapted to selectively pass light in one of two distinct linear states (P1, P2) of polarization, and
c) an irradiance sensor (96) that detects the spatial distribution of light passing the pinhole (82) and being in either of said two linear states (P1, P2) of polarization.

13. The instrument of claim 12, wherein the polarizer (130) is a polarization filter that is mounted so as to be rotatable around an axis which is parallel to an optical axis (88) of the instrument (80).

14. The instrument of claim 12 or 13, wherein the irradiance sensor (96) displays a maximum sensibility difference for light which is in one (P1) of the two linear states of polarization and light which is in the other (P2) of the two linear states of polarization.

15. An instrument for measuring the angular distribution of light produced by an illumination system (12) of a microlithographic projection exposure apparatus (10), comprising:
a) a pinhole (82),
b) an aspherical lens (90), and
c) an irradiance sensor (96) that detects the spatial distribution of light after it has passed the pinhole (82) and the lens (90).

16. A projection exposure apparatus, comprising an illumination system (12) and the instrument (80; 80') of any of the preceding claims, wherein the pinhole (82) is arranged at least substantially in an illumination plane (70) of the illumination system (12) where a mask (16) is positioned during exposure operation.

17. A method of measuring the angular distribution of light produced by an illumination system (12) of a microlithographic projection exposure apparatus (10), comprising the following steps:
a) positioning a pinhole (82) in an illumination plane (70) of the illumination system (12);
b) providing an irradiance sensor (96) that detects the spatial distribution of light haying passed the pinhole (82), wherein the irradiance sensor (96) displays a maximum sensibility difference for light which is in a first linear state of polarization (P1) and light which is in a second linear state of polarization (P2);
c) measuring the sensibility of the irradiance sensor (96) for light impinging in the first linear state of polarization (P1);
d) measuring the sensibility of the irradiance sensor (96) for light impinging in the second linear state of polarization (P2);
e) providing a polarizer (130) that passes light in the first linear states of polarization (P1);
f) detecting the spatial distribution of light passing the pinhole (82) and being in the first linear state of polarization (P1);
g) providing a polarizer (130) that passes light in the second linear states of polarization (P2);
h) detecting the spatial distribution of light passing the pinhole (82) and being in the second linear state of polarization (P2);
i) determining the total irradiances for the light impinging on the irradiance sensor (96) in both linear states of polarizations (P1, P2), thereby taking into account the sensibility measured in steps c) and d).
